# EUROPÄISCHE PATENTSCHRIFT

(11) **EP 3 300 199 B1**
(45) Veröffentlichungstag und Bekanntmachung des Hinweises auf die Patenterteilung: **25.10.2023**
(21) Anmeldenummer: 16190142.6
(22) Anmeldetag: 22.09.2016
(51) Int. Cl.: H02H 3/02, H01H 9/56, H02H 3/08, H02H 7/22, G01R 19/25, H01H 33/02, H01H 33/59, G01R 19/175, G01R 15/18

(54) **VERFAHREN UND EINRICHTUNG ZUM ANSTEUERN EINES LEISTUNGSSCHALTERS FÜR EIN ELEKTRISCHES ENERGIEVERSORGUNGSNETZ IM NULLDURCHGANG DES STROMES**
METHOD AND DEVICE OF CONTROLLING A CIRCUIT BREAKER FOR AN ELECTRICAL ENERGY SUPPLY SYSTEM AT CURRENT ZERO CROSSING
PROCÉDÉ ET DISPOSITIF DESTINÉS À CONTRÔLER UN DISJONCTEUR POUR UN RÉSEAU D'ALIMENTATION EN ÉNERGIE ÉLECTRIQUE LORS DU PASSAGE À ZÉRO DU COURANT

(43) Veröffentlichungstag der Anmeldung: 28.03.2018
(73) Patentinhaber: Siemens Aktiengesellschaft, 80333 München (DE)
(72) Erfinder: Herrmann, Hans-Joachim, 91459 Markt Erlbach (DE)
(74) Vertreter: Siemens Patent Attorneys

(56) Entgegenhaltungen:
- EP-A1- 1 928 007
- WO-A1-03/050831
- WO-A1-2005/031374
- WO-A1-2015/056326
- CN-B- 102 882 402
- DE-A1-102011 107 721
- US-B1- 8 786 991

## Beschreibung

Die Erfindung betrifft ein Verfahren zum Ansteuern eines Leistungsschalters in einem elektrischen Energieversorgungsnetz, bei dem mittels eines schutz- oder leittechnischen Gerätes des Energieversorgungsnetzes ein Schaltsignal erzeugt wird und das Schaltsignal an eine einen Antrieb des Leistungsschalters umfassende Steuereinheit des Leistungsschalters übertragen wird, wobei die Steuereinheit bei Empfang des Schaltsignals zum Öffnen der Schaltkontakte des Leistungsschalters veranlasst wird; und ein durch den Leistungsschalter fließender Strom erfasst und hinsichtlich des Auftretens von Nulldurchgängen überprüft wird; und eine Weitergabe des Schaltsignals an die Steuereinheit so lange verhindert wird, bis zumindest ein Nulldurchgang erkannt worden ist.

Die Erfindung betrifft auch eine Einrichtung zum Ansteuern eines Leistungsschalters in einem elektrischen Energieversorgungsnetz.

Ein solches Verfahren ist aus der US 8,786,991 B1 bekannt.

Außerdem ist beispielsweise aus der WO 2015/028062 A1 ein Verfahren bekannt, bei dem mittels eines Differentialschutzgerätes im Fall eines im Energieversorgungsnetz aufgetretenen Fehlers ein Schaltsignal in Form eines Fehlersignals erzeugt und an einen Leistungsschalter übermittelt wird, damit dieser zum Öffnen seiner Schaltkontakte veranlasst wird.

Weiterer relevanter Stand der Technik wird in der EP 1 928 007 A1 und in der CA 02927413 A1 beschrieben.

Bei Einschaltvorgängen bzw. bei Fehlern, z.B. Kurzschlüssen, im Energieversorgungsnetz kann es unter bestimmten Bedingungen dazu kommen, dass der mit dem Leistungsschalter zu unterbrechende Strom einen hohen Gleichstromanteil aufweist. Dieser Effekt wird insbesondere in Energieversorgungsnetzen mit einem großen induktiven Anteil beobachtet, wie sie beispielsweise durch Drosselspulen hervorgerufen werden.

Bei ungünstigen Schalt- bzw. Fehlereintrittszuständen bzw. Netzparametern (z.B. bei großen netzseitigen Zeitkonstanten, beispielsweise bei hohem induktiven Anteil im Verhältnis zum ohmschen Anteil) ist es möglich, dass der durch den Leistungsschalter fließende Strom aufgrund des Gleichstromgliedes temporär keine Nulldurchgänge mehr aufweist.

Dies kann sich insbesondere deshalb kritisch auswirken, weil ein Leistungsschalter einen beim Ausschalten üblicherweise entstehenden Schaltlichtbogen nur unterdrücken kann, wenn ein Stromnulldurchgang vorhanden ist. Der eigentliche Schaltvorgang erfolgt prinzipiell im Stromnulldurchgang. Fehlt ein Nulldurchgang, brennt der Schaltlichtbogen weiter und kann im schlimmsten Fall zur Zerstörung des Leistungsschalters führen.

Daher ist es üblich, durch dynamische Netzberechnungen zu analysieren, ob ein Auftreten des oben geschilderten Effekts möglich ist. Durch geeignete Simulationsrechnungen werden die ungünstigsten Bedingungen ermittelt, unter denen ein Strom mit fehlenden Nulldurchgängen auftreten kann. Daraus ergibt sich die maximale theoretisch mögliche Zeit der Nulldurchgangsfreiheit des Stromes. Um eine Beschädigung des Leistungsschalters durch einen Schaltvorgang während einer Phase mit fehlenden Nulldurchgängen auszuschließen, wird das Schaltsignal entsprechend verzögert. Die einzustellende Zeit wird aus den Simulationsrechnungen zuzüglich eines Sicherheitsaufschlags ermittelt. Nachteilig an diesem Vorgehen ist, dass die Zeitverzögerung prinzipiell auf alle Schaltsignale angewendet wird, so dass das Ausschalten des Leistungsschalters ausschließlich mit der eingestellten Verzögerung erfolgt. Das widerspricht jedoch der grundlegenden Philosophie des Netzschutzes, wonach nach einem eingetretenen Fehler die Schadensausweitung durch eine möglichst rasche Fehlerabschaltung zu begrenzen ist. Außerdem fordern sogenannte "Gridcodes" (Vorgaben für das Betreiben eines Energieversorgungsnetzes) gewisse Fehlerklärungszeiten insbesondere zur Gewährleistung der Netzstabilität.

Der Erfindung liegt die Aufgabe zugrunde, auch in solchen Energieversorgungsnetzen, in denen nulldurchgangsfreie Phasen des durch einen Leistungsschalter zu schaltenden Stroms auftreten können, einen möglichst schnellen Schaltvorgang zu gewährleisten.

Zur Lösung dieser Aufgabe wird ein Verfahren der eingangs angegebenen Art vorgeschlagen, bei dem die Steuereinheit mittels einer Schalterkontrolleinrichtung nach Empfang des Schaltsignals einen optimalen Schaltzeitpunkt des Leistungsschalters ermittelt und den Antrieb entsprechend ansteuert, um den Leistungsschalter möglichst nah bezüglich eines Stromnulldurchgangs zu öffnen.

Bei der erfindungsgemäßen Lösung kann gewährleistet werden, dass die Steuereinheit des Leistungsschalters so schnell, wie es der aktuelle Zustand des Energieversorgungsnetzes erlaubt, mit dem Schaltsignal beaufschlagt wird. Die Steuereinheit umfasst einerseits den Antrieb des Leistungsschalters und andererseits eine Schalterkontrolleinrichtung, die nach Empfang des Schaltsignals z.B. den optimalen Schaltzeitpunkt des Leitungsschalters ermittelt und den Antrieb entsprechend ansteuert.

Hierzu wird der durch den Leistungsschalter fließende Strom auf Stromnulldurchgänge untersucht. Sobald diese vorliegen, wird das Schaltsignal an die Steuereinheit des Leistungsschalters weitergeleitet. Es muss somit kein Ablauf einer fest eingestellten Verzögerungszeit abgewartet werden, bevor das Schaltsignal weitergegeben wird, so dass unmittelbar wenn Nulldurchgänge vorhanden sind und damit ein sicheres Schalten des Leistungsschalters gewährleistet ist, das Schaltsignal weitergegeben wird.

Das Verfahren kann in einem mehrphasigen Energieversorgungsnetz, z.B. im Dreiphasensystem, für jeden Ausschaltkreis separat durchgeführt werden.

Eine vorteilhafte Ausführungsform des erfindungsgemäßen Verfahrens sieht vor, dass mittels des schutz- oder leittechnischen Gerätes eine Überwachung eines von dem Leistungsschalter begrenzten Abschnitts des Energieversorgungsnetzes hinsichtlich des Auftretens eines Fehlers durchgeführt wird und bei Erkennung eines Fehlers bezüglich des Abschnitts von dem Schutzgerät das Schaltsignal erzeugt wird.

Bei dieser Ausführungsform wird das Schaltsignal infolge einer Schutzüberwachung des fraglichen Abschnitts hinsichtlich etwaiger Fehler, z.B. Kurzschlüsse, erzeugt.

Zur Überwachung von Primärkomponenten (z.B. Kabeln, Leitungen, Transformatoren etc.) elektrischer Energieversorgungsnetze werden sogenannte schutz- oder leittechnische Geräte eingesetzt, um unzulässige Betriebszustände der jeweils überwachten Primärkomponente, die beispielsweise durch Kurzschlüsse oder Erdkurzschlüsse hervorgerufen sein können, zu erkennen und automatisch abzuschalten. Hierzu nimmt das schütz- oder leittechnische Gerät üblicherweise an einer oder mehreren Messstellen in dem Energieversorgungsnetz Messgrößen auf, beispielsweise in Form von Strom- und/oder Spannungsmesswerten, die den Betriebszustand der Primärkomponente charakterisieren. Zur Ausführung seiner Schutzfunktion, wertet das Gerät daraufhin die Messgrößen unter Ausführung eines sogenannten Schutzalgorithmus, also einer Berechnungs- und/oder logischen Verknüpfungsvorschrift zur Auswertung der aufgenommenen Messgrößen, aus und erzeugt in Abhängigkeit vom Ergebnis der Auswertung gegebenenfalls ein Fehlersignal, das einen mit dem Gerät in Verbindung stehenden Leistungsschalter zum Öffnen seiner Schaltkontakte veranlasst, um den fehlerbehafteten Abschnitt vom übrigen Energieversorgungsnetz abzutrennen.

Beispiele häufig zur Überwachung von Energieversorgungsnetzen eingesetzter Schutzalgorithmen sind das Distanzschutzverfahren, das Differentialschutzverfahren oder das Überstromschutzverfahren. Diese und andere Schutzverfahren sind dem Fachmann hinlänglich bekannt und werden daher hier nicht vertiefend behandelt.

Alternativ zu einem Schaltsignal, dass infolge einer Schutzüberwachung erzeugt wird, kann auch vorgesehen sein, dass mittels des schutz- oder leittechnischen Gerätes das Schaltsignal bei Empfang eines externen Ausschaltbefehls erzeugt wird.

Der externe Ausschaltbefehl kann dabei beispielsweise entweder durch eine manuelle Schalthandlung des Bedienpersonals des Energieversorgungsnetzes oder durch ein entsprechendes Regelsignal aus einer Leitwarte veranlasst werden.

Eine weitere vorteilhafte Ausführungsform des erfindungsgemäßen Verfahrens sieht in diesem Zusammenhang vor, dass für jede Periodendauer des durch den Leistungsschalter fließenden Stroms ein Nulldurchgang dann erkannt wird, wenn ein Wechsel des Vorzeichens des Stroms erkannt wird.

Auf diese Weise kann ein Stromnulldurchgang sehr einfach, nämlich durch bloße Betrachtung des Vorzeichens des durch den Leistungsschalter fließenden Stroms, erkannt werden.

Gemäß einer weiteren vorteilhaften Ausführungsform des erfindungsgemäßen Verfahrens kann vorgesehen sein, dass mittels des schutz- oder leittechnischen Gerätes ein Freigabesignal erzeugt wird, wenn zumindest ein Nulldurchgang hinsichtlich des durch den Leistungsschalter fließenden Stromes erkannt worden ist, und das Schaltsignal dann an die Steuereinheit weitergeleitet wird, wenn sowohl das Schaltsignal als auch das Freigabesignal vorliegen.

Auf diese Weise kann die Weiterleitung des Schaltsignals schaltungstechnisch besonders einfach gelöst werden, da hierzu lediglich eine einfache logische Verknüpfung des Schaltsignals mit dem Freigabesignal, beispielsweise über ein UND-Glied, erfolgen muss. Stehen beide Signale zur gleichen Zeit an, so wird das Schaltsignal an die Steuereinheit des Leistungsschalters weitergeleitet.

In diesem Zusammenhang kann gemäß einer vorteilhaften Weiterbildung des erfindungsgemäßen Verfahrens zudem vorgesehen sein, dass das Freigabesignal zyklisch pro Periodendauer des durch den Leistungsschalter fließenden Stroms erzeugt wird.

Auf diese Weise wird das Freigabesignal kontinuierlich an die jeweils bestehenden Netzverhältnisse angepasst. So kann z.B. durch die zyklische Überprüfung der Voraussetzungen des Freigabesignals gewährleistet werden, dass beim erneuten Ausbleiben von Nulldurchgängen nach einem bereits erkannten Nulldurchgang das Freigabesignal wieder zurückgenommen wird.

Konkret kann im Rahmen der Erfindung zudem vorgesehen sein, dass zur Ermittlung der Periodendauer des Stroms die Frequenz des durch den Leistungsschalter fließenden Stroms bestimmt wird.

Die Ermittlung der Frequenz kann nach einem üblichen Frequenzmessverfahren durchgeführt werden. Bei Kenntnis der Frequenz lässt sich die Periodendauer einfach bestimmen.

Gemäß einer weiteren vorteilhaften Ausführungsform des erfindungsgemäßen Verfahrens kann zudem vorgesehen sein, dass eine Weitergabe des Schaltsignals an die Steuereinheit so lange verhindert wird, bis mindestens eine vorgegebene Anzahl von Nulldurchgängen erkannt worden ist.

Bei dieser Ausführungsform kann sichergestellt werden, dass das Schaltsignal nicht bereits bei einem einzelnen erkannten Nulldurchgang an die Steuereinheit weitergeleitet wird, sondern eine gewisse Anzahl von Nulldurchgängen aufgetreten sein müssen, bevor das Schaltsignal weitergeleitet wird. Hierdurch kann die Robustheit des Verfahrens gegen Messfehler und Ungenauigkeiten erhöht werden.

Gemäß einer weiteren vorteilhaften Ausführungsform des erfindungsgemäßen Verfahrens kann zudem vorgesehen sein, dass das Schaltsignal unabhängig vom Vorliegen von Nulldurchgängen hinsichtlich des durch den Leistungsschalter fließenden Stroms an die Steuereinheit weitergegeben wird, wenn seit der Erzeugung des Schaltsignals eine vorgegebene Zeitdauer abgelaufen ist, wobei die vorgegebene Zeitdauer eine maximal tolerierbare Zeit angibt, die bis zur Durchführung des Schaltvorgangs nicht überschritten werden darf.

Hierdurch kann sichergestellt werden, dass nach Ablauf einer maximal tolerierbaren Zeit das Schaltsignal auf jeden Fall an die Steuereinheit weitergegeben wird, so dass eine maximale Dauer bis zur Durchführung des Schaltvorgangs nicht überschritten wird.

Da wie erläutert insbesondere Gleichstromglieder eine wesentliche Ursache für die Nulldurchgangsfreiheit sind, muss die Übertragung des Gleichstromgliedes durch die Stromwandler im Messverfahren berücksichtigt werden. Das ist insbesondere bei Stromwandlern mit kleiner Stromwandlerzeitkonstante erforderlich, da diese quasi das aperiodische Gleichstromglied herausfiltern. Im vom Stromwandler sekundärseitig abgegebenen Strom ist dabei kaum ein Gleichstromglied vorhanden und es wird somit ein Strom mit Nulldurchgängen vorgetäuscht.

Daher wird gemäß einer weiteren vorteilhaften Ausführungsform des erfindungsgemäßen Verfahrens vorgeschlagen, dass der durch den Leistungsschalter fließende Strom mittels eines Stromwandlers erfasst wird und der von dem Stromwandler sekundärseitig abgegebene Stromverlauf einer Korrektur unterzogen wird, um ein im primärseitig vorliegenden Strom enthaltenes Gleichstromglied sekundärseitig abzubilden.

Konkret kann hierfür vorgesehen sein, dass zur Korrektur des von dem Stromwandler sekundärseitig abgegebenen Stromverlaufs ein digitales Filter verwendet wird, dessen Koeffizienten in Abhängigkeit vom Stromwandlertyp und/oder einer Zeitkonstanten des Stromwandlers gebildet sind.

Mit diesen Angaben kann eine verlässliche Korrektur des sekundärseitig abgegebenen Stroms durchgeführt werden.

Eine weitere vorteilhafte Ausführungsform des erfindungsgemäßen Verfahrens sieht vor, dass die Überprüfung des durch den Leistungsschalter fließenden Stroms hinsichtlich des Auftretens von Nulldurchgängen im schutz- oder leittechnischen Gerät durchgeführt wird.

Hierdurch kann die Überprüfung, ob das Schaltsignal weitergegeben werden kann, vorteilhaft in demselben Gerät durchgeführt werden, das auch das Schaltsignal erzeugt.

Alternativ dazu kann aber auch vorgesehen sein, dass die Überprüfung des durch den Leistungsschalter fließenden Stroms hinsichtlich des Auftretens von Nulldurchgängen in einer dem schutz- oder leittechnischen Gerät nachgeordneten und dem Leistungsschalter vorgeordneten Einrichtung durchgeführt wird.

Hierbei wird die Überprüfung, ob das Schaltsignal weitergegeben werden kann, mit einer separaten Einrichtung durchgeführt.

Die oben genannte Aufgabe wird auch durch ein System mit einer Einrichtung zum Ansteuern eines Leistungsschalters in einem elektrischen Energieversorgungsnetz und einer Steuereinheit des Leistungsschalters gelöst, wobei die Einrichtung einen Signaleingang zum Empfangen eines mittels eines schutz- oder leittechnischen Gerätes des Energieversorgungsnetzes erzeugten Schaltsignals aufweist und wobei die Einrichtung einen Signalausgang zum Abgeben des Schaltsignals an die Steuereinheit des Leistungsschalters aufweist wobei die Einrichtung dazu ausgebildet ist, einen durch den Leistungsschalter fließenden Strom hinsichtlich des Auftretens von Nulldurchgängen zu überprüfen und die Einrichtung dazu ausgebildet ist, eine Weitergabe des Schaltsignals an die Steuereinheit so lange zu verhindern, bis zumindest ein Nulldurchgang erkannt worden ist.

Erfindungsgemäß umfasst die Steuereinheit eine Schalterkontrolleinrichtung und einen Antrieb des Leistungsschalters, wobei die Schalterkontrolleinrichtung dazu eingerichtet ist, nach Empfang des Schaltsignals einen optimalen Schaltzeitpunkt des Leistungsschalters zu ermitteln und den Antrieb entsprechend anzusteuern, um den Leistungsschalter möglichst nah bezüglich eines Stromnulldurchgangs zu öffnen..

Hinsichtlich der erfindungsgemäßen Einrichtung gelten alle zu dem erfindungsgemäßen Verfahren voranstehend und nachfolgend gemachten Ausführungen und umgekehrt in entsprechender Weise, insbesondere ist die erfindungsgemäße Einrichtung zur Durchführung des erfindungsgemäßen Verfahrens in jeder beliebigen Ausführungsform oder einer Kombination beliebiger Ausführungsformen eingerichtet. Auch hinsichtlich der Vorteile der erfindungsgemäßen Einrichtung wird auf die zu dem erfindungsgemäßen Verfahren beschriebenen Vorteile verwiesen.

Konkret kann bezüglich der erfindungsgemäßen Einrichtung vorgesehen sein, dass die Einrichtung in das schütz- oder leittechnische Gerät integriert oder als von dem schutz- oder leittechnischen Gerät separate Einrichtung ausgebildet ist.

Die Erfindung wird nachfolgend anhand eines Ausführungsbeispiels näher erläutert. Die spezifische Ausgestaltung des Ausführungsbeispiels ist für die allgemeine Ausgestaltung des erfindungsgemäßen Verfahrens und der erfindungsgemäßen Einrichtung in keiner Weise einschränkend zu verstehen; vielmehr können einzelne Ausgestaltungsmerkmale des Ausführungsbeispiels in beliebiger Weise frei untereinander und mit den voranstehend beschriebenen Merkmalen kombiniert werden.

Hierzu zeigen
- Figur 1: eine schematische Ansicht eines mittels eines schutz- oder leittechnischen Geräts überwachten Abschnitts eines elektrischen Energieversorgungsnetzes;
- Figur 2: ein Diagramm mit beispielhaften Stromverläufen während eines Einschaltvorgangs;
- Figur 3: Diagramme mit beispielhaften Stromverläufen während eines einphasigen Fehlers;
- Figur 4: ein Diagramm mit beispielhaften Stromverläufen während eines dreiphasigen Fehlers;
- Figur 5: ein Diagramm mit Verläufen des Primärund des Sekundärstroms eines Stromwandlers mit einer kleinen Stromwandlerzeitkonstanten;
- Figur 6: ein beispielhaftes Ablaufdiagramm zur Erläuterung eines Verfahrens zum Ansteuern eines Leistungsschalters; und
- Figur 7: ein Diagramm mit Verläufen des Primärund des Sekundärstroms eines Stromwandlers sowie eines korrigierten Sekundärstroms.

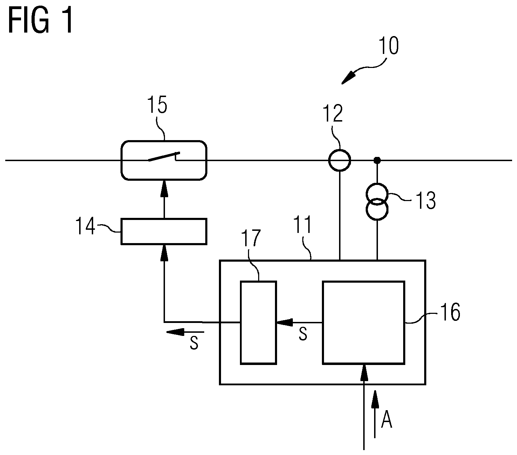

Figur 1 zeigt einen Abschnitt 10 eines im Weiteren nicht dargestellten elektrischen Energieversorgungsnetzes. Bei dem Abschnitt 10 kann es sich beispielsweise um eine Leitung des Energieversorgungsnetzes handeln. Stattdessen kann der Abschnitt 10 aber auch andere Primärkomponenten (Transformatoren, Generatoren, etc.) oder eine Kombination davon des Energieversorgungsnetzes umfassen.

Der Abschnitt 10 wird mittels eines schutz- oder leittechnischen Gerätes 11 hinsichtlich des Auftretens von Fehlern, z.B. Kurzschlüssen, überwacht. Dazu werden mittels eines Stromwandlers 12 und eines Spannungswandlers 13 Messwerte erfasst, die den durch den Abschnitt 10 fließenden Strom bzw. die am Abschnitt 10 anliegende Spannung angeben. Mittels des schutz- oder leittechnischen Gerätes 11 werden die aufgenommenen Messwerte mittels einer Recheneinrichtung 16 (z.B. einem entsprechend programmierten Mikroprozessor) unter Verwendung sogenannter Schutzalgorithmen (z.B. Distanzschutzalgorithmus, Differentialschutzalgorithmus, Überstromschutzalgorithmus etc.) daraufhin überprüft, ob sie einen auf dem überwachten Abschnitt 10 vorliegenden Fehler angeben. Sofern ein Fehler erkannt worden ist, wird von der Recheneinrichtung 16 des schutz- oder leittechnischen Geräts ein Schaltsignal S erzeugt, das an eine Steuereinheit 14 weitergeleitet wird, die einem Leistungsschalter 15 zugeordnet ist. Die Steuereinheit umfasst einen Schalterantrieb zum Bewegen zumindest eines Schaltkontakts des Leistungsschalters sowie eine Schalterkontrolleinrichtung, die das Schaltsignal S in geeigneter Weise zur Ansteuerung des Leistungsschalters umsetzt, z.B. indem ein optimaler Schaltzeitpunkt ermittelt wird, um den Leistungsschalter möglichst nah bezüglich eines Stromnulldurchgangs des durch den Leistungsschalter fließenden Stroms zu öffnen. Desweiteren können mit der Schalterkontrolleinrichtung auch Wiedereinschaltfunktionen des Leistungsschalters und andere Schalterfunktionen ausgeführt werden.

Zwar ist der Abschnitt 10 in Figur 1 der Einfachheit halber in Form eines einphasigen Systems dargestellt. Das nachfolgend beschriebene Verfahren zur Ansteuerung eines Leistungsschalters kann jedoch ebenso in mehrphasigen, insbesondere dreiphasigen, Systemen zum Einsatz kommen.

Schaltvorgänge und Fehler in Energieversorgungsnetzen mit einem signifikanten Anteil an Induktivitäten können dazu führen, dass dem durch den Leistungsschalter 15 fließenden Strom temporär Gleichstromgliedern überlagert sind. Dieser Effekt besteht insbesondere in Energieversorgungsnetzen mit großen Zeitkonstanten (L/R), also mit einem im Vergleich zum induktiven Anteil geringen ohmschen Anteil. Abhängig vom Schaltzustand bzw. Fehlereintritt können sich die Stromverläufe hierbei so ausbilden, dass keine Stromnulldurchgänge auftreten.

Wechselstromkreise können prinzipiell durch einen Leistungsschalter problemlos beherrscht werden, wenn der Strom über Nulldurchgänge verfügt. Der Leistungsschalter unterbricht den Stromkreis im Nulldurchgang. Fehlt jedoch der Stromnulldurchgang, kann der beim Ausschaltvorgang auftretende Lichtbogen nicht mehr unterdrückt werden und der Leistungsschalter wird thermisch überbeansprucht. Eine Zerstörung des Leistungsschalters kann nicht ausgeschlossen werden.

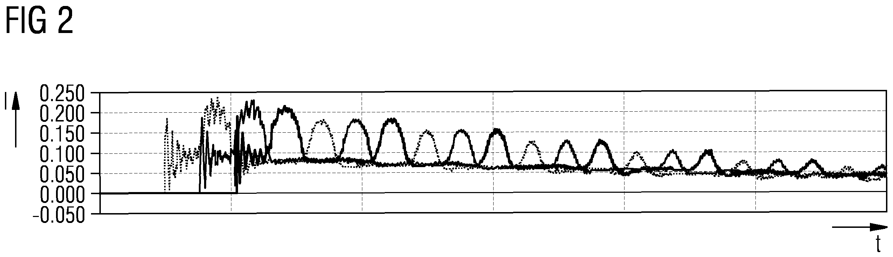

Figur 2 zeigt ein Diagramm mit Verläufen von Phasenströmen, in dem dieser Effekt bei einem Einschaltvorgang eines Seekabels dargestellt ist. Das Seekabel ist durch Drosseln kompensiert und weist dadurch einen signifikanten Anteil an Induktivitäten auf. Aufgrund der großen Induktivitäten tritt der bekannte Einschaltvorgang auf, bei dem es zu großen Gleichstromzeitkonstanten und damit zur Nulldurchgangsfreiheit kommt. In Figur 2 erkennt man, dass bis zum Ende der aufgetragenen Zeitdauer kein Nulldurchgang auftritt.

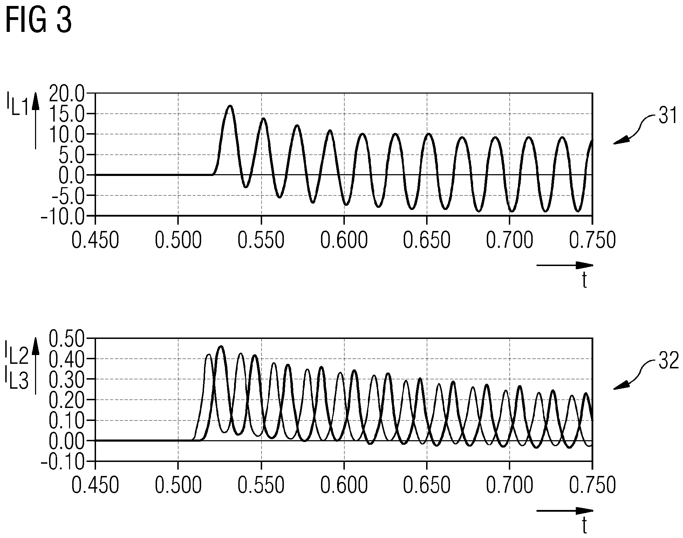

In Figur 3 ist beispielhaft der Verlauf der Phasenströme während eines einphasigen Erdkurzschlusses gezeigt. Die fehlerbehaftete Phase L1 ist im oberen Diagramm 31 gezeigt, während die nicht von dem Fehler betroffenen Phasen L2 und L3 im unteren Diagramm dargestellt sind. Der Fehlerstrom der Phase L1 zeigt den typischen Kurzschlussstromverlauf mit überlagertem Gleichstromglied. Durch die Anlagenkonstellation tritt jetzt eine Verlagerung in den beiden fehlerfreien Leitern L2, L3 auf. Diese weisen für eine gewisse Zeit nach Fehlereintritt keine Nulldurchgänge auf.

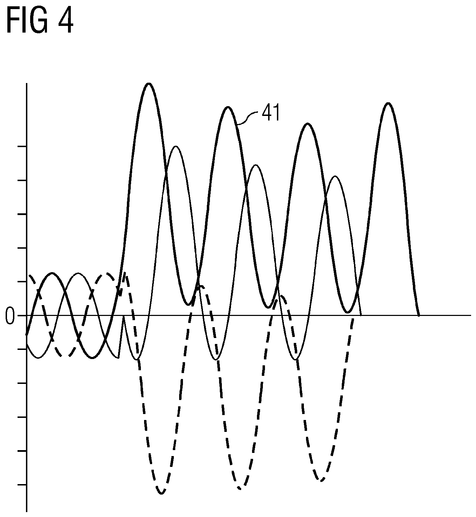

Ein weiteres Beispiel eines Fehlers, bei dem temporär keine Stromnulldurchgänge auftreten, ist in Figur 4 gezeigt. In dem in Figur 4 dargestellten Diagramm ist die Situation gezeigt, in der ein dreipoliger Kurzschluss nicht gleichzeitig in allen Phasen auftritt. Im Spannungsnulldurchgang der verketteten Spannung tritt ein zweipoliger Kurzschluss auf (damit maximales Gleichstromglied) und geht nach einer Viertel Periode später in einen dreipoligen Kurzschluss über. Die in Figur 4 mit dem Bezugszeichen 41 gekennzeichnete Phase weist hierbei temporär keine Nulldurchgänge auf.

Um auch in Situationen, in denen ein oder mehrere Phasenströme keine Nulldurchgänge aufweisen, den Strom sicher mit dem Leistungsschalter unterbrechen zu können, wird ein erzeugtes Schaltsignal S nicht direkt an die Steuereinheit 14 (vgl. Figur 1) des Leistungsschalters 15 weitergegeben. Vielmehr wird mittels einer Einrichtung 17 zur Ansteuerung des Leistungsschalters 15 der durch diesen fließende Strom, beispielsweise in Form des sekundärseitig von dem Stromwandler 12 abgegebenen Stromes, erfasst, abgetastet und bezüglich des Auftretens von Nulldurchgängen untersucht. Alternativ ist auch der Einsatz eines separaten Stromwandlers zum Zwecke der Nulldurchgangserkennung möglich. Ein Nulldurchgang kann beispielsweise anhand eines stattfindenden Vorzeichenwechsels zwischen zwei aufeinanderfolgenden Messwerten erkannt werden. Erst wenn mindestens ein Nulldurchgang erkannt worden ist, wird von der Einrichtung 17 das anstehende Schaltsignal S an die Steuereinheit 14 des Leistungsschalters 15 weitergeleitet. Es kann zudem vorgesehen sein, dass eine Mindestanzahl von Nulldurchgängen erkannt worden sein muss, damit das Schaltsignal S an die Steuereinheit 14 des Leistungsschalters 15 weitergeleitet wird. Hierdurch kann das Verfahren relativ robust gegen Messungenauigkeiten ausgebildet werden.

Das schutz- oder leittechnische Gerät 11 kann auch derart ausgebildet sein, dass es ein Schaltsignal S erzeugt, wenn es einen externen Ausschaltbefehl A empfängt. Dieser externe Ausschaltbefehl A kann beispielsweise in einer Netzleitstelle von einem Netzsteuersystem erzeugt und an das schütz- oder leittechnische Gerät 11 übertragen werden. Alternativ dazu kann ein externer Ausschaltbefehl A auch über eine manuelle Eingabe an einer Bedieneinheit des schutz- oder leittechnischen Gerätes 11 eingegeben werden.

In dem Ausführungsbeispiel der Figur 1 ist die Einrichtung 17 in dem schütz- oder leittechnischen Gerät 11 integriert. Alternativ dazu kann es sich bei der Einrichtung allerdings auch um eine separate Einrichtung (nicht in Figur 1 dargestellt) handeln, die dem schutz- oder leittechnischen Gerät 11 nachgeordnet und der Steuereinheit 14 vorgeordnet ist.

Konkret kann beispielsweise vorgesehen sein, dass die Einrichtung 17 ein Freigabesignal erzeugt, wenn zumindest ein Nulldurchgang in dem durch den Leistungsschalter 15 fließenden Strom erkannt worden ist. Liegen sowohl das Freigabesignal als auch das Schaltsignal S gleichzeitig vor, so wird das Schaltsignal an die Steuereinheit 14 des Leistungsschalters 15 weitergegeben.

Die in Figuren 2 bis 4 dargestellten Stromverläufe zeigen jeweils den auf der Primärseite des Stromwandlers 12 vorliegenden Strom. Der vom schutz- oder leittechnischen Gerät 11 bzw. der Einrichtung 17 verarbeitete Sekundärstrom wird durch den Stromwandler nicht exakt abgebildet. Ein Stromwandler weist nämlich üblicherweise Eigenschaften eines Hochpassgliedes auf und beeinflusst damit signifikant die Übertragung des Gleichstromgliedes. Je kleiner die Stromwandlerzeitkonstante, desto höher ist die Grenzfrequenz. Das Gleichstromglied wird damit stärker unterdrückt. Linearkernwandler (TPZ-Wandler) sind ein typischer Vertreter für diesen Fall.

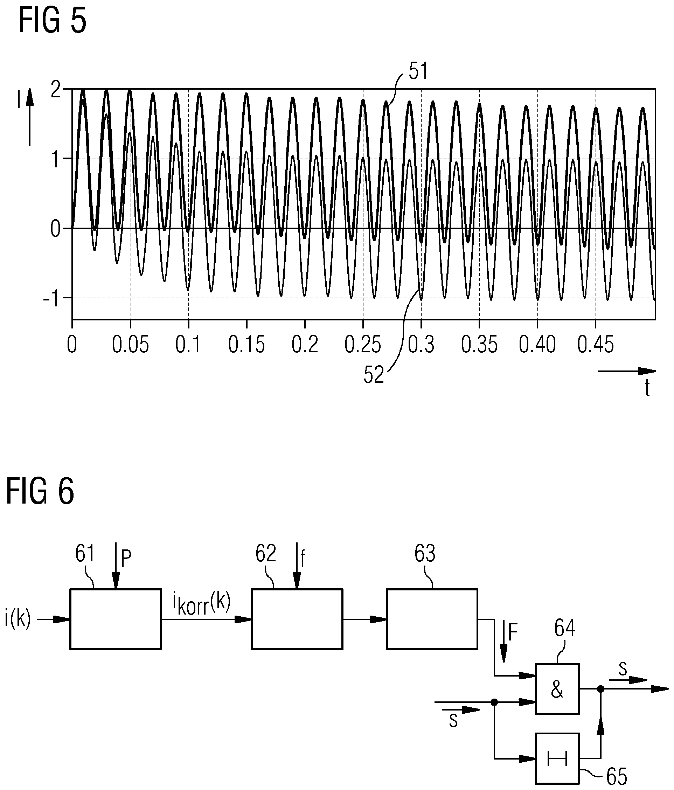

In Figur 5 ist das Übertragungsverhalten eines Stromwandlers bezüglich eines Stromes mit Gleichstromglied gezeigt. Man erkennt, dass der Stromverlauf 52 des Sekundärstroms hinsichtlich des Gleichstromglieds im Vergleich zum Stromverlauf 51 des Primärstroms verfälscht übertragen wird.

Eine kritische Situation ist bei extremen Bedingungen gegeben, in denen eine große Netzzeitkonstante (z.B. während eines Einschaltvorgang, sogenannter "In-Rush") im Sekundenbereich mit der Übertragung durch einen Linearkernwandler (kleine Wandlerzeitkonstante) zusammentrifft. Durch die verfälschte Übertragung des Gleichstromglieds sind im Sekundärstromverlauf Nulldurchgänge ersichtlich, die keine Entsprechung auf der Primärstromseite haben. Aus diesem Grund ist es für die Durchführung des oben erläuterten Verfahrens zur Ansteuerung des Leistungsschalters in einigen Fällen notwendig, eine Korrektur des von dem Stromwandler 12 sekundärseitig abgegebenen Stroms durchzuführen.

Ein beispielhaftes Ablaufdiagramm zur Durchführung eines Verfahrens zum Ansteuern eines Leistungsschalters ist in Figur 6 dargestellt. Zwar zeigt Figur 6 zur Erläuterung des Verfahrens mehrere einzelne Blöcke, das Verfahren kann jedoch auch in einer entsprechenden Softwareprogrammierung für einen Prozessor implementiert sein. Das Verfahren wird von der Einrichtung 17 ausgeführt.

Wie bereits oben zu Figur 1 erläutert, besteht der Kern des Verfahrens darin, ein Schaltsignal S erst zur Steuereinheit 14 des Leitungsschalters 15 weiterzugeben, wenn im durch den Leistungsschalter 15 fließenden Strom Stromnulldurchgänge auftreten. Dazu wird zunächst der sekundärseitig vom Stromwandler abgegebene Strom i(k) erfasst. Im Block 61 wird der Strom i(k) durch ein zusätzliches Filter so korrigiert, dass ein im Primärstrom vorhandenes Gleichstromglied möglichst genau im sekundären Strom abgebildet wird. Dazu wird der abgetastete Strom wird durch ein Korrekturfilter geschickt, um das ursprüngliche Gleichstromglied, welches dem Primärstrom entspricht, zu rekonstruieren. Der überlagerte sinusförmige Anteil wird getreu übertragen. über Eingabeparameter P hinsichtlich des Wandlertyps (z.B. P, PX, TPZ,...) und/oder eine Wandlerzeitkonstante (z.B. 1s, 60 ms) werden die Filterkoeffizienten des zur Korrektur verwendeten Filters ermittelt. Ausgangsseitig werden von dem Filter korrigierte Sekundärstromwerte iₖₒᵣᵣ(k) abgegeben. Diese werden einem Block 62 zugeführt.

Im Block 62 wird über ein Messverfahren (z.B. Betrachtung eines Vorzeichenwechsels der Abtastwerte) kontinuierlich (im Drehstromsystem pro Phase) der Strom auf Nulldurchgänge überprüft. Die Überprüfung erfolgt vorzugsweise zyklisch innerhalb einer Netzperiode, da durch die mögliche Gleichgliedverlagerung eine Verschiebung des Stromes auftreten kann. Zur Bestimmung der Netzperiode ist die aktuelle Netzfrequenz f erforderlich. Diese wird über ein geeignetes Frequenzmessverfahren ermittelt und dem Block 62 bereitgestellt.

Der korrigierte Sekundärstrom iₖₒᵣᵣ(k) wird hinsichtlich der Nulldurchgänge untersucht. Bei gefundenen Nulldurchgängen wird in Block 63 ein Freigabesignal F abgesetzt. Dieses Freigabesignal F wird zyklisch ermittelt und erneuert.

Ein von der Recheneinrichtung 16 (vgl. Figur 1) erzeugtes Schaltsignal S wird dann an die Steuereinheit 14 weitergeleitet, wenn eingangsseitig an einem UND-Glied 64 sowohl das Schaltsignal S als auch das Freigabesignal anliegen.

In einer optionalen Ausführungsform kann zudem ein Zeitglied 65 vorgesehen sein, das ebenfalls mit dem Schaltsignal S beaufschlagt ist und dieses - unabhängig vom Vorliegen eines Freigabesignals - an die Steuereinheit weiterleitet, wenn eine vorgegebene Zeitdauer abgelaufen ist. Hierdurch kann sichergestellt werden, dass das Schaltsignal S in jedem Fall spätestens nach Ablauf der vorgegebenen Zeitdauer zu einer Schalthandlung führt.

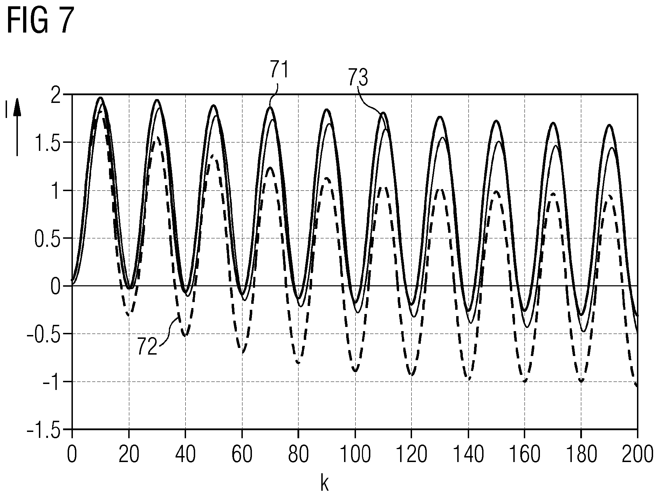

In Figur 7 ist beispielhaft die Wirkung des Korrekturfilters (Block 61 in Figur 6) dargestellt. Kurve 71gibt den Primärstrom mit einem Gleichstromglied an. Kurve 72 zeigt den (unkorrigierten) Sekundärstrom i(k) des Stromwandlers, der dem Block 61 zugeführt wird. Man erkennt deutlich, dass im unkorrigierten Fall eine Unterdrückung des Gleichstromgliedes stattfindet. Durch das digitale Korrekturfilter wird möglichst genau der Primärstrom nachgebildet. Der korrigierte Strom ikorr(k) ist als Kurve 73 in Figur 7 gezeigt.

Obwohl die Erfindung vorstehend im Detail durch bevorzugte Ausführungsbeispiele näher illustriert und beschrieben worden ist, ist die Erfindung nicht durch die offenbarten Beispiele eingeschränkt und andere Variationen können vom Fachmann hieraus abgeleitet werden, ohne den Schutzumfang der nachfolgenden Patentansprüche zu verlassen.

## Patentansprüche

1. Verfahren zum Ansteuern eines Leistungsschalters (15) eines elektrischen Energieversorgungsnetzes, bei dem
- mittels eines schutz- oder leittechnischen Gerätes (11) ein Schaltsignal erzeugt wird; und
- das Schaltsignal an eine einen Antrieb des Leistungsschalters (15) umfassende Steuereinheit (14) des Leistungsschalters (15) übertragen wird, wobei die Steuereinheit (14) bei Empfang des Schaltsignals zum Öffnen der Schaltkontakte des Leistungsschalters (15) veranlasst wird;
- ein durch den Leistungsschalter (15) fließender Strom erfasst und hinsichtlich des Auftretens von Nulldurchgängen überprüft wird; und
- eine Weitergabe des Schaltsignals an die Steuereinheit (14) so lange verhindert wird, bis zumindest ein Nulldurchgang erkannt worden ist;
**dadurch gekennzeichnet, dass**
- die Steuereinheit (14) mittels einer Schalterkontrolleinrichtung nach Empfang des Schaltsignals einen optimalen Schaltzeitpunkt des Leistungsschalters ermittelt und den Antrieb entsprechend ansteuert, um den Leistungsschalter möglichst nah bezüglich eines Stromnulldurchgangs zu öffnen.

2. Verfahren nach Anspruch 1,
**dadurch gekennzeichnet, dass**
- mittels des schutz- oder leittechnischen Gerätes (11) eine Überwachung eines von dem Leistungsschalter (15) begrenzten Abschnitts (10) des Energieversorgungsnetzes hinsichtlich des Auftretens eines Fehlers durchgeführt wird; und
- bei Erkennung eines Fehlers bezüglich des Abschnitts (10) von dem schutz- oder leittechnischen Gerät (11) das Schaltsignal erzeugt wird.

3. Verfahren nach Anspruch 1,
**dadurch gekennzeichnet, dass**
- mittels des schutz- oder leittechnischen Gerätes (11) das Schaltsignal bei Empfang eines externen Ausschaltbefehls erzeugt wird.

4. Verfahren nach einem der vorangehenden Ansprüche,
**dadurch gekennzeichnet, dass**
- für jede Periodendauer des durch den Leistungsschalter (15) fließenden Stroms ein Nulldurchgang dann erkannt wird, wenn ein Wechsel des Vorzeichens des Stroms erkannt wird.

5. Verfahren nach einem der vorangehenden Ansprüche,
**dadurch gekennzeichnet, dass**
- mittels des schutz- oder leittechnischen Gerätes (11) ein Freigabesignal erzeugt wird, wenn zumindest ein Nulldurchgang hinsichtlich des durch den Leistungsschalter (15) fließenden Stromes erkannt worden ist; und
- das Schaltsignal dann an die Steuereinheit (14) weitergeleitet wird, wenn sowohl das Schaltsignal als auch das Freigabesignal vorliegen.

6. Verfahren nach Anspruch 5
**dadurch gekennzeichnet, dass**
- das Freigabesignal zyklisch pro Periodendauer des durch den Leistungsschalter (15) fließenden Stroms erzeugt wird.

7. Verfahren nach einem der Ansprüche 5 oder 6,
**dadurch gekennzeichnet, dass**
- zur Ermittlung der Periodendauer des Stroms die Frequenz des durch den Leistungsschalter (15) fließenden Stroms bestimmt wird.

8. Verfahren nach einem der vorangehenden Ansprüche,
**dadurch gekennzeichnet, dass**
- eine Weitergabe des Schaltsignals an die Steuereinheit (14) so lange verhindert wird, bis mindestens eine vorgegebene Anzahl von Nulldurchgängen erkannt worden ist.

9. Verfahren nach einem der vorangehenden Ansprüche,
**dadurch gekennzeichnet, dass**
- das Schaltsignal unabhängig vom Vorliegen von Nulldurchgängen hinsichtlich des durch den Leistungsschalter (15) fließenden Stroms an die Steuereinheit (14) weitergegeben wird, wenn seit der Erzeugung des Schaltsignals eine vorgegebene Zeitdauer abgelaufen ist, wobei die vorgegebene Zeitdauer eine maximal tolerierbare Zeit angibt, die bis zur Durchführung des Schaltvorgangs nicht überschritten werden darf.

10. Verfahren nach einem der vorangehenden Ansprüche,
**dadurch gekennzeichnet, dass**
- der durch den Leistungsschalter (15) fließende Strom mittels eines Stromwandlers (12) erfasst wird; und
- der von dem Stromwandler (12) sekundärseitig abgegebene Stromverlauf einer Korrektur unterzogen wird, um ein im primärseitig vorliegenden Strom enthaltenes Gleichstromglied sekundärseitig abzubilden.

11. Verfahren nach Anspruch 10,
**dadurch gekennzeichnet, dass**
- zur Korrektur des von dem Stromwandler (12) sekundärseitig abgegebenen Stromverlaufs ein digitales Filter verwendet wird, dessen Koeffizienten in Abhängigkeit vom Stromwandlertyp und/oder einer Zeitkonstanten des Stromwandlers (12) gebildet sind.

12. Verfahren nach einem der vorangehenden Ansprüche,
**dadurch gekennzeichnet, dass**
- die Überprüfung des durch den Leistungsschalter (15) fließenden Stroms hinsichtlich des Auftretens von Nulldurchgängen im schutz- oder leittechnischen Gerät (11) durchgeführt wird.

13. Verfahren nach einem der Ansprüche 1 bis 11,
**dadurch gekennzeichnet, dass**
- die Überprüfung des durch den Leistungsschalter (15) fließenden Stroms hinsichtlich des Auftretens von Nulldurchgängen in einer dem schutz- oder leittechnischen Gerät (11) nachgeordneten und dem Leistungsschalter (15) vorgeordneten Einrichtung durchgeführt wird.

14. System mit einer Einrichtung zum Ansteuern eines Leistungsschalters (15) eines elektrischen Energieversorgungsnetzes und einer Steuereinheit (14) des Leistungsschalters; wobei
- die Einrichtung einen Signaleingang zum Empfangen eines Schaltsignals aufweist; und wobei
- die Einrichtung einen Signalausgang zum Abgeben des Schaltsignals an die Steuereinheit (14) des Leistungsschalters (15) aufweist; wobei
- die Einrichtung dazu ausgebildet ist, einen durch den Leistungsschalter (15) fließenden Strom hinsichtlich des Auftretens von Nulldurchgängen zu überprüfen; und
- die Einrichtung dazu ausgebildet ist, eine Weitergabe des Schaltsignals an die Steuereinheit (14) so lange zu verhindern, bis zumindest ein Nulldurchgang erkannt worden ist;
**dadurch gekennzeichnet, dass**
- die Steuereinheit (14) eine Schalterkontrolleinrichtung und einen Antrieb des Leistungsschalters umfasst, wobei die Schalterkontrolleinrichtung dazu eingerichtet ist, nach Empfang des Schaltsignals einen optimalen Schaltzeitpunkt des Leistungsschalters zu ermitteln und den Antrieb entsprechend anzusteuern, um den Leistungsschalter möglichst nah bezüglich eines Stromnulldurchgangs zu öffnen.

15. System nach Anspruch 14,
**dadurch gekennzeichnet, dass**
- die Einrichtung in ein schutz- oder leittechnisches Gerät (11) integriert oder als von einem schutz- oder leittechnischen Gerät (11) separate Einrichtung ausgebildet ist.

## Claims

1. Method for controlling a circuit breaker (15) in an electrical energy supply network, in which
- a switching signal is generated by means of a protective or control device (11); and
- the switching signal is transmitted to a control unit (14) of the circuit breaker (15), said control unit comprising a drive of the circuit breaker (15), the control unit (14) being caused to open the switching contacts of the circuit breaker (15) upon reception of the switching signal;
- a current flowing through the circuit breaker (15) is recorded and is checked for the occurrence of zero crossings; and
- forwarding of the switching signal to the control unit (14) is prevented until at least one zero crossing has been detected;
**characterized in that**
- the control unit (14) uses a switch control device to determine an optimum switching time of the circuit breaker after receiving the switching signal and accordingly controls the drive in order to open the circuit breaker as close as possible to a current zero crossing.

2. Method according to Claim 1,
**characterized in that**
- a section (10) of the energy supply network which is limited by the circuit breaker (15) is monitored for the occurrence of a fault by means of the protective or control device (11); and
- the switching signal is generated by the protective or control device (11) if a fault is detected with respect to the section (10).

3. Method according to Claim 1,
**characterized in that**
- the switching signal is generated by means of the protective or control device (11) upon reception of an external switch-off command.

4. Method according to one of the preceding claims,
**characterized in that**
- a zero crossing is detected for each period duration of the current flowing through the circuit breaker (15) when a change in the sign of the current is detected.

5. Method according to one of the preceding claims,
**characterized in that**
- a release signal is generated by means of the protective or control device (11) if at least one zero crossing has been detected with regard to the current flowing through the circuit breaker (15); and
- the switching signal is forwarded to the control unit (14) when both the switching signal and the release signal are present.

6. Method according to Claim 5,
**characterized in that**
- the release signal is generated cyclically for each period duration of the current flowing through the circuit breaker (15).

7. Method according to either of Claims 5 and 6,
**characterized in that**
- the frequency of the current flowing through the circuit breaker (15) is determined in order to determine the period duration of the current.

8. Method according to one of the preceding claims,
**characterized in that**
- forwarding of the switching signal to the control unit (14) is prevented until at least a predefined number of zero crossings has been detected.

9. Method according to one of the preceding claims,
**characterized in that**
- the switching signal is forwarded to the control unit (14) independently of the presence of zero crossings with regard to the current flowing through the circuit breaker (15) if a predefined period has expired since the generation of the switching signal, the predefined period indicating a maximum tolerable time which must not be exceeded until the switching operation is carried out.

10. Method according to one of the preceding claims,
**characterized in that**
- the current flowing through the circuit breaker (15) is recorded using a current transformer (12); and
- the current profile output by the current transformer (12) on the secondary side is subjected to a correction in order to model a DC element, contained in the current present on the primary side, on the secondary side.

11. Method according to Claim 10,
**characterized in that**
- a digital filter is used to correct the current profile output by the current transformer (12) on the secondary side, the coefficients of which filter are formed on the basis of the current transformer type and/or a time constant of the current transformer (12).

12. Method according to one of the preceding claims, **characterized in that**
- the current flowing through the circuit breaker (15) is checked for the occurrence of zero crossings in the protective or control device (11).

13. Method according to one of Claims 1 to 11,
**characterized in that**
- the current flowing through the circuit breaker (15) is checked for the occurrence of zero crossings in an apparatus which is arranged downstream of the protective or control device (11) and is arranged upstream of the circuit breaker (15) .

14. System having an apparatus for controlling a circuit breaker (15) in an electrical energy supply network and a control unit (14) of the circuit breaker;
- the apparatus having a signal input for receiving a switching signal; and
- the apparatus having a signal output for outputting the switching signal to a control unit (14) of the circuit breaker (15) ;
- the apparatus being designed to check a current flowing through the circuit breaker (15) for the occurrence of zero crossings; and
- the apparatus being designed to prevent forwarding of the switching signal to the control unit (14) until at least one zero crossing has been detected;
**characterized in that**
- the control unit (14) comprises a switch control device and a drive of the circuit breaker, the switch control device being configured to determine an optimum switching time of the circuit breaker after receiving the switching signal and to accordingly control the drive in order to open the circuit breaker as close as possible to a current zero crossing.

15. System according to Claim 14,
**characterized in that**
- the apparatus is integrated in a protective or control device (11) or is in the form of an apparatus separate from a protective or control device (11).

## Revendications

1. Procédé de commande d'un disjoncteur (15) d'un réseau d'alimentation en énergie électrique, dans lequel
- on produit un signal de coupure au moyen d'un appareil (11) de la technique de protection ou de conduction ; et
- on transmet le signal de coupure à une unité (14) de commande, comprenant un entraînement du disjoncteur (15), du disjoncteur (15), dans lequel l'unité (14) de commande provoque à la réception du signal de coupure l'ouverture des contacts de coupure du disjoncteur (15) ;
- on détecte un courant passant dans le disjoncteur (15) et on le contrôle en ce qui concerne l'apparition de passages par zéro ; et
- on empêche un acheminement du signal de coupure à l'unité (14) de commande jusqu'à ce qu'au moins un passage par zéro a été détecté ;
**caractérisé en ce que**
- l'unité (14) de commande détermine, au moyen d'un dispositif de contrôle de disjoncteur, après la réception du signal de coupure, un instant optimal de coupure du disjoncteur et commande en conséquence l'entraînement afin d'ouvrir le disjoncteur aussi près que possible d'un passage par zéro du courant.

2. Procédé suivant la revendication 1,
**caractérisé en ce que**
- au moyen de l'appareil (11) de la technique de protection ou de conduction, on effectue un contrôle d'une partie (10), délimitée par le disjoncteur (15) du réseau d'alimentation en énergie en ce qui concerne l'apparition d'un défaut ; et
- à la détection d'un défaut en ce qui concerne le tronçon (10), on produit le signal de coupure par l'appareil (11) de la technique de protection ou de conduction.

3. Procédé suivant la revendication 1,
**caractérisé en ce que**
- au moyen de l'appareil (11) de la technique de protection ou de conduction, on produit le signal de coupure à la réception d'une instruction extérieure de mise hors circuit.

4. Procédé suivant l'une des revendications précédentes,
**caractérisé en ce que**
- pour chaque période du courant passant dans le disjoncteur (15), on détecte un passage par zéro lorsque l'on détecte un changement du signe du courant.

5. Procédé suivant l'une des revendications précédentes,
**caractérisé en ce que**
- au moyen de l'appareil (11) de la technique de protection ou de conduction, on produit un signal de validation s'il a été détecté au moins un passage par zéro concernant le courant passant dans le disjoncteur (15) ; et
- on achemine le signal de coupure à l'unité (14) de commande s'il y a à la fois le signal de coupure et le signal de validation.

6. Procédé suivant la revendication 5,
**caractérisé en ce que**
- on produit le signal de validation cycliquement par période du courant passant dans le disjoncteur (15).

7. Procédé suivant l'une des revendications 5 ou 6,
**caractérisé en ce que**
- on détermine la fréquence du courant passant dans le disjoncteur (15) pour la détermination de la période du courant.

8. Procédé suivant l'une des revendications précédentes,
**caractérisé en ce que**
- on empêche un acheminement du signal de coupure à l'unité (14) de commande jusqu'à ce qu'au moins un nombre donné à l'avance de passages par zéro a été détecté.

9. Procédé suivant l'une des revendications précédentes,
**caractérisé en ce que**
- on acheminement à l'unité (14) de commande le signal de coupure indépendamment de la présence de passages par zéro en ce qui concerne le courant passant par le disjoncteur (15), si depuis la production du signal de courant s'est écoulée une durée donnée à l'avance, dans lequel la durée donnée à l'avance indique un temps pouvant être toléré au maximum, qui ne doit pas être dépassé jusqu'à ce que l'on effectue l'opération de coupure.

10. Procédé suivant l'une des revendications précédentes,
**caractérisé en ce que**
- on détecte un courant passant dans le disjoncteur (15) au moyen d'un transformateur (12) de courant ; et
- on soumet la courbe de courant donnée du côté secondaire par le transformateur (12) de courant à une correction pour former du côté secondaire une composante de courant continu contenue dans le courant présent du côté primaire.

11. Procédé suivant la revendication 10,
**caractérisé en ce que**
- pour la correction du courant donné du côté secondaire par le transformateur (12) de courant, on utilise un filtre numérique, dont les coefficients sont formés en fonction du type de transformateur de courant et/ou d'une constante de temps du transformateur (12) de courant.

12. Procédé suivant l'une des revendications précédentes,
**caractérisé en ce que**
- on effectue le contrôle du courant passant dans le disjoncteur (15) en ce qui concerne l'apparition de passages par zéro dans l'appareil (11) de la technique de protection ou de conduction.

13. Procédé suivant l'une des revendications 1 à 11,
**caractérisé en ce que**
- on effectue le contrôle du courant passant dans le disjoncteur (15) en ce qui concerne l'apparition de passages par zéro dans un dispositif monté en aval de l'appareil (11) de la technique de protection ou de conduction et monté en amont du disjoncteur (15) .

14. Système comprenant un dispositif de commande d'un disjoncteur (15) d'un réseau d'alimentation en énergie électrique et une unité (14) de commande du disjoncteur, dans lequel
- le dispositif a une entrée de signal pour la réception d'un signal de coupure ; et dans lequel
- le dispositif a une sortie de signal pour donner le signal de coupure à l'unité (14) de commande du disjoncteur (15), dans lequel
- le dispositif est constitué pour contrôler un courant passant dans le disjoncteur (15) en ce qui concerne l'apparition de passages par zéro ; et
- le dispositif est constitué pour empêcher un acheminement du signal de coupure à l'unité (14) de commande jusqu'à ce qu'au moins un passage par zéro a été détecté ;
**caractérisé en ce que**
- l'unité (14) de commande comprend un dispositif de contrôle de disjoncteur et un entraînement du disjoncteur, dans lequel le dispositif de contrôle du disjoncteur est agencé de manière à déterminer, après la réception du signal de coupure, un instant optimum de coupure du disjoncteur et à commander en conséquence l'entraînement afin d'ouvrir le disjoncteur aussi près que possible d'un passage par zéro du courant.

15. Système suivant la revendication 14,
**caractérisé en ce que**
- le dispositif est intégré dans un appareil (11) de la technique de production ou de conduction ou est constitué sous la forme d'un dispositif distinct d'un appareil (11) de la technique de protection ou de conduction.
